Europäisches Patentamt

European Patent Office

Office européen des brevets

(11) Veröffentlichungsnummer: **0 046 216**
A2

# EUROPÄISCHE PATENTANMELDUNG

(21) Anmeldenummer: **81105924.5**

(51) Int. Cl.³: **G 11 C 11/40**

(22) Anmeldetag: **27.07.81**

(30) Priorität: **19.08.80 DE 3031299**

(43) Veröffentlichungstag der Anmeldung: **24.02.82**
**Patentblatt 82/8**

(84) Benannte Vertragsstaaten: **DE FR GB**

(71) Anmelder: **SIEMENS AKTIENGESELLSCHAFT Berlin und München, Postfach 22 02 61, D-8000 München 22 (DE)**

(72) Erfinder: **Giebel, Burkhard, Dipl.-Ing., Asenweg 15, D-8000 München 83 (DE)**

(54) **Treiberstufe für eine statische MOS-Halbleiter-Digitalschaltung.**

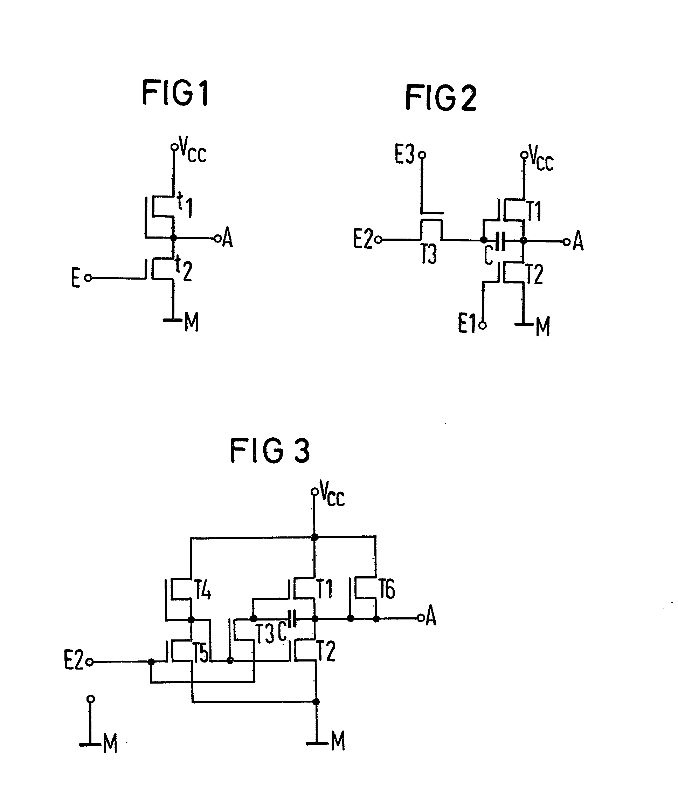

(57) Bei bekannten MOS-Treiberstufen hat man zwei bezüglich ihrer Source-Drainstrecken in Serie liegenden und an ihren freien stromführenden Anschlüssen an je einem der beiden Versorgungspotentiale ($V_{CC}$, M) liegende MOS-FET's, bei denen das Gate des an Masse liegenden und selbstsperrenden zweiten MOS-FET (T2) signalgesteuert ist, während das Gate des ersten MOS-FET (T1) an dem durch einen Schaltungspunkt zwischen den beiden MOS-FET's (T1, T2) liegenden Ausgang (A) der Treiberstufe verbunden ist (Fig. 1). Diese Schaltung erfordert zwar einen geringen schaltungstechnischen Aufwand. Jedoch wären mitunter kürzere Schaltzeiten der durch sie gesteuerten digitalen Halbleiterschaltungen wünschenswert. Es ist deshalb Aufgabe der Erfindung, die bekannte Treiberschaltung in dieser Beziehung zu verbessern.

Erfindungsgemäß ist deshalb die soeben definierte Treiberstufe derart ausgestaltet, daß die Kopplung des Gates des ersten MOS-FET's (T1) mit dem Ausgang (A) nicht unmittelbar erfolgt, sondern über einen Kondensator (C) gegeben ist. Außerdem ist ein dritter MOS-FET (T3) gegeben, dessen Source-Drainstrecke einerseits am Gate des ersten MOS-FET (T1) liegt und andererseits durch ein vom Steuersignal (S1) am Gate des zweiten MOS-FET (T2) unterschiedliches Steuersignal (S2) beaufschlagt ist.

EP 0 046 216 A2

0046216

Siemens Aktiengesellschaft        Unser Zeichen
Berlin und München                VPA  80 P 1 1 3 4 E

Treiberstufe für eine statische MOS-Halbleiter-Digital-schaltung

Die Erfindung bezieht sich auf eine Treiberstufe für eine statische MOS-Halbleiter-Digitalschaltung, bei der zwei MOS-Feldeffekttransistoren bezüglich ihrer Source-Drainstrecken in Serie liegen und dabei der Drain des ersten MOS-Feldeffekttransistors an ein erstes Betriebspotential und der Sourceanschluß des zweiten MOS-Feldeffekttransistors an ein als Bezugspotential (Masse) geschaltetes zweites Betriebspotential gelegt ist, bei der ferner der Signalausgang durch einen Schaltungspunkt zwischen dem ersten und dem zweiten Feldeffekttransistor gegeben ist, bei der außerdem das Gate des als Anreicherungstyptransistor ausgestalteten zweiten MOS-Feldeffekttransistors signalgesteuert und das Gate des ersten MOS-Feldeffekttransistors allgemein an den Signalausgang der Treiberstufe gekoppelt ist.

Solche Treiberstufen werden in statischen MOS-Schaltungen häufig benötigt und eingesetzt. Zum Beispiel werden solche - bekanntlich Verstärkereigenschaften aufweisende -Stufen zum Treiben von Signalleitungen bei statischen MOS-Speichern benötigt. Festzustellen ist dabei, daß die Schaltzeit solcher Treiberstufen stark die resultierende Schaltzeit der Gesamtschaltung beeinflußt. Es ist deshalb abgestrebt, den Einfluß der Treiberstufen auf die Schaltzeit der Gesamtschaltung möglichst zu reduzieren bzw. möglichst rasch arbeitende Treiberstufen herzustellen. Die bisher bekannten Lösungen bringen jedoch in der Regel einen relativ hohen Leistungsbedarf mit sich.

Besonders empfindlich inbezug auf den Leistungsverbrauch und die Schaltgeschwindigkeit der verwendeten Treiberstufen sind statische MOS-Speicherschaltungen, die mit nur einer

0046216

Versorgungsspannung arbeiten, da in einer solchen Schaltung die zur Ansteuerung der Speicherzellen in der Speichermatrix erforderlichen Zeilen-Auswahlleitungen möglichst schnell geschaltet werden sollen. Daraus folgt, daß die Zahl für einen solchen Speicher benötigten Treiberstufen sowie deren Leistungsverbrauch mit der Speicherkapazität der Speicherschaltung wächst. Ferner benötigt man ausreichende H- und L-Pegel am Ausgang der Treiberschaltung. Dieser Forderung konnte in ausreichendem Maße bislang nur durch Treiberschaltungen entsprochen werden, bei denen ein MOS-Feldeffekttransistor vom Verarmungstyp die angeschlossene Leitung des Speichers auf den H-Pegel und ein MOS-Feldeffekttransistor vom Anreicherungstyp die Leitung auf den L-Pegel schaltet.

Die einfachste Schaltung dieser Art entspricht der eingangs gebrachten Definition und ist in Fig. 1 dargestellt. Bei dieser ist der Steuereingang E der Treiberstufe durch das Gate eines Transistors $t_2$ vom Anreicherungstyp gegeben, dessen Sourceanschluß am Bezugspotential, also Masse, liegt und dessen Drainanschluß den Treiberausgang A bildet. Der Drainanschluß des nach obiger Definition den zweiten Transistor der Schaltung bildenden Transistors $t_2$ ist unmittelbar mit dem Sourceanschluß sowie mit dem Gate des ersten Transistors $t_1$ verbunden, der vom Verarmungstyp ist und entsprechend der obigen Definition am ersten Betriebspotential $V_{CC}$ liegt. Beide Transistoren sind vom selben Kanaltyp.

Der Nachteil dieser Schaltung ist, daß bei L-Pegel des Ausgangs A - bedingt durch den immer leitenden ersten Transistor $t_1$ - ein statischer Leistungsverbrauch gegeben ist.

Um diesen Nachteil zu vermeiden, wird gemäß der Erfindung vorgeschlagen, daß die Kopplung des Gates des ersten MOS-Feldeffekttransistors mit dem Ausgang A der Treiberstufe
durch einen Kondensator C gegeben ist, daß außerdem ein
dritter MOS-Feldeffekttransistor gegeben ist, dessen
Source-Drainstrecke einerseits am Gate des ersten MOS-
Feldeffekttransistors liegt und andererseits durch ein
vom Steuersignal am Gate des zweiten MOS-Feldeffekttransistors unterschiedliches Steuersignal beaufschlagt ist.

Vorzugsweise ist dabei der erste Transistor nicht vom
Verarmungstyp, sondern besitzt eine Einsatzspannung $U_T$
nahe 0 Volt oder darüber.

In Figur 2 ist die allgemeinste Ausgestaltung einer Treiberstufe gemäß der Erfindung und in Figur 3 eine bevorzugte Ausgestaltung dargestellt. Dabei sind für übereinstimmende Schaltungsteile dieselben Bezugszeichen verwendet.

Bei der in Fig. 2 dargestellten Ausgestaltung der erfindungsgemäßen Treiberstufe liegt der erste Transistor T1
mit seinem Drain am ersten Betriebspotential $V_{CC}$ und der
Sourceanschluß des zweiten Transistors T2 am Bezugspotential, also an Masse, wie dies auch im Fall der bekannten
Schaltung gemäß Fig. 1 zutrifft. Das Gate des zweiten
Transistors T2 wird über den dem Steuereingang E der
Fig. 1 entsprechenden Eingang E1 mit einem Steuersignal
S1 beaufschlagt. Der Ausgang A der Treiberstufe liegt
zwischen den beiden Transistoren T1 und T2, die somit der
Inverterstufe gemäß Fig. 1 entsprechen. Jedoch ist in Abweichung zur bekannten Schaltung ein Kondensator C vorgesehen, der einerseits an einen Schaltungspunkt
zwischen den beiden Transistoren T1 und T2 und andererseits an das Gate des ersten Transistors T1 angeschlossen ist, so daß die Ankopplung des Gates des Transistors
T1 an den Ausgang A kapazitiv und nicht wie im Falle der
Treiberstufe gemäß Fig. 1 galvanisch ist. Das Gate des
Transistors T1 liegt ferner am Drainanschluß eines dritten MOS-Feldeffekttransistors T3, dessen Source an einen Schaltungspunkt E2 angeschlossen ist, der mit einem Signal S2 beaufschlagt wird, während das Gate des dritten MOS-Feldeffekttransistors T3 über einen dritten Schaltungspunkt E3 durch ein Signal S3 gesteuert ist. Dabei ist vorgeschrieben, daß die Steuersignale S2 und S3 voneinander verschieden sein müssen, während es, wie Fig. 3 zeigt, angebracht sein kann, wenn die Steuersignale S1 und S3 identisch sind. Im Falle der Ausgestaltung gemäß Fig. 3 sind die Steuersignale S1 und S2 zueinander invertiert, wobei das Steuersignal S2 auf keinen Fall zeitlich hinter dem zugehörigen Steuersignal S1 liegt.

Gemäß einer weiteren Ausbildung der Erfindung ist vorgesehen, daß der den Treiberausgang A auf die Versorgungsspannung aufladende erste Transistor T1 durch einen sperrbaren Enhancement-Transistor gegeben ist. Auf jeden Fall empfiehlt es sich, wenn der erste MOS-Feldeffekttransistor T1 eine möglichst kleine Schwellspannung, also praktisch die Schwellspannung 0 Volt hat, um den statischen Leistungsverbrauch beim logischen Zustand "0" am Treiberausgang A zu vermeiden.

Durch die Anwesenheit des Kondensators C als Kopplungselement zwischen dem Gate des ersten Transistors T1 und dem Ausgang A der Treiberstufe wird erreicht, daß das Gatepotential des Transistors T1 über das Potential der Spannungsversorgung hinaus angehoben wird. Außerdem führt der dritte MOS-Feldeffekttransistor T3 dazu, daß die im Kondensator C gespeicherte Ladung nur abfließt, wenn der dritte Transistor T3 leitend geschaltet ist.

Zunächst ist das zur Steuerung des Gates des dritten Transistors T3 vorgesehene Signal S3 durch eine Konstantspannung gegeben. Die Verwendung eines einen konstanten Pegel aufweisenden Signals am Gate des dritten Transistors T3 bedeutet eine gewisse Schaltungsvereinfachung.

Die in Fig. 3 angegebene Erzeugungsweise für das Signal S3 führt dagegen zu einem verbesserten Schaltverhalten der Treiberstufe, da ein Ladungsrückfluß aus dem Kondensator C ausgeschlossen werden kann und der Transistor T3 geometrisch kleiner ausgelegt werden kann und somit mit geringeren parasitären Kapazitäten behaftet ist. Zu bemerken ist, daß der dritte Transistor sowohl vom Anreicherungstyp, als auch vom Verarmungstyp sein kann.

Im Falle der Verwendung eines durch eine konstante Spannung gegebenen Signals S3 empfiehlt sich, daß die sich durch Addition aus dem H-Pegel (= High-Pegel) des am Sourceanschluß des dritten Transistors T3 liegenden Signals S2 und der Einsatzspannung, also der Schwellspannung $U_T$ des dritten MOS-Feldeffekttransistors T3, ergebende Summenspannung größer als die das Signal S3 darstellende Konstantspannung ist.

Die in Fig. 3 angegebene Erzeugungsweise für das Signal S3 dagegen bringt die Forderung mit sich, daß die sich durch Addition aus dem H-Pegel des Signals S2 und der Schwellspannung $U_T$ des dritten Transistors T3 ergebende Summenspannung größer als der L-Pegel (=Low-Pegel) der das Signal S3 darstellenden Gatespannung des Transistors T3 ist.

Bezüglich des Kanaltyps der in der Treiberstufe gemäß der Erfindung zu verwendenden MOS-Feldeffekttransistoren ist zu erwähnen, daß sämtliche Transistoren denselben Kanaltyp aufweisen, der sich nach dem Kanaltyp der übrigen, die erfindungsgemäße Treiberstufe als Bestandteil enthaltenden statischen MOS-Digitalschaltung richtet. Bevorzugt handelt es sich um n-Kanal MOS-FET's.

Bei der in Fig. 3 dargestellten Ausgestaltung einer Treiberstufe gemäß der Erfindung sind noch drei weitere MOS-Feldeffekttransistoren T4, T5 und T6 vorgesehen, wobei die

0046216

Transistoren T4 und T5 (ebenso wie die Transistoren T1 und T2) einen Inverter bilden. Der Inverter aus den Transistoren T4 und T5 wird am Signaleingang E2 durch digitales Steuersignal angesteuert, das außerdem das Signal, S2 für die Source des dritten Transistors T3 bildet. Der Eingang des Inverters T4, T5 ist durch das Gate des mit seinem Sourceanschluß durch das Bezugspotential M beaufschlagten MOS-Feldeffekttransistors T5 gegeben, der wiederum als Anreicherungstyp-MOS-FET ausgebildet ist. Der mit ihm in Serie liegende Transistor T4 ist ein als Last geschalteter, also gate-source-verbundener Verarmungstyptransistor. Der Ausgang des Inverters T4, T5 ist mit E1 bezeichnet, da er das zur Steuerung des Gates des zweiten Transistors T2 dienende Steuersignal S1 liefert. Der Drain des Transistors T4 liegt am ersten Betriebspotential $V_{CC}$.

Zur Erzeugung eines Ausgangs-H-Pegels in Höhe der sich aus der Differenz der beiden Betriebspotentiale $V_{CC}$ und M (=Masse) ergebenden Versorgungsspannung benötigt der erste Transistor T1 eine Gatespannung, die mindestens um seine Einsatzspannung $U_T$ größer ist als die Versorgungsspannung. Eine solche Gatespannung wird dem ersten Transistor T1 über einen Bootstrap-Kondensator C zugeführt, der für den H-Pegel an seinem vom Ausgang A der Treiberschaltung abgewandten Pol durch den gemäß der Erfindung vorgesehenen dritten MOS-Feldeffekttransistor T3 gegen die übrige Schaltung isoliert ist, also nicht entladen werden kann. Zur Ansteuerung des Gates des dritten Transistors T3 dient das über die Inverterschaltung T4, T5 gewonnene invertierte Steuersignal, das am Eingang E2 eingespeist wird.

Bei Tiefpegel (L-Pegel) an E2 ist der dritte Transistor T3 leitend, so daß der Bootstrap-Kondensator C entladen und der erste Transistor T1 gesperrt ist. Gleichzeitig erzeugt der zweite Transistor den Low-Pegel am Ausgang A des Treibers.

Beim Wechsel des Steuerpegels am Steuereingang E2 der Schaltung von L nach H folgt der Ausgang A der Treiberstufe dem Eingangssignal zunächst nicht. Die für das Umschalten des Eingangsinverters T4, T5 benötigte Zeitspanne wird bei der erfindungsgemäßen Treiberstufe gemäß Figur 3 ausgenutzt, um den Bootstrap-Kondensator C vorzuladen. Erreicht nun die Gatespannung des dritten Transistors T3 einen Wert, bei dem dieser in den sperrenden Zustand übergeht, dann wird dem Kondensator C eine weitere Änderung seines Ladungszustands verwehrt. Der durch den Ausgang E1 des Inverters T4, T5 gesteuerte zweite Transistor T2 geht schließlich in den Sperrzustand über, während gleichzeitig über den ersten Transistor T1 der H-Pegel in Höhe der Versorgungsspannung am Ausgang A der Treiberstufe entsteht.

Beim Wechsel des Pegels des am Eingang E2 der Treiberstufe liegenden Signals von H nach L wird der dritte Transistor T3 wieder leitend und damit eine rasche Entladung des Kondensators C gegeben und die Gatespannung des ersten Transistors T1 abgebaut. Dadurch wird der erste Transistor T1 gesperrt und der zweite Transistor T2 in die Lage gebracht, den erforderlichen L-Pegel am Ausgang A des Treibers zu erzeugen.

Ein in der Schaltung gemäß Fig. 3 vorgesehener Transistor T6 hat die Aufgabe, dann wirksam zu werden, wenn sich bei Eingangs- wie Ausgangs-Hoch-Pegel der Kondensator C über parasitäre Widerstände der Schaltung entladen kann. Dann sorgt der zweckmäßig als hochohmiger Depletiontyp-Transistor ausgestaltete MOS-Feldeffekttransistor T6 statisch für einen Ausgangspegel in Höhe der Versorgungsspannung, sofern der Ausgang A der Treiberschaltung nur kapazitiv belastet ist.

Bei entsprechender Dimensionierung ist zur Erzeugung eines Ausgangspegels in Höhe der Versorgungsspannung

0046216

80 P 1 1 3 4 E

$V_{CC}$ - M ein Eingangspegel , der kleiner ist als die Versorgungsspannung durchaus ausreichend. Wird die Schaltung gemäß Fig. 3 bzw. Fig. 2 z.B. als Verstärker für eine NOR-Dekoderschaltung verwendet, so kann der Dekoder ohne weiteres mit MOS-Feldeffekttransistoren vom Anreicherungstyp (= Enhancement-Typ) als selektierbare Lasttransistoren ausgestaltet werden, was den Vorteil einer weiteren erheblichen Verminderung der Leistungsaufnahme der Gesamtschaltung mit sich bringt.

Bei der in Fig. 3 dargestellten bevorzugten Ausgestaltung einer Treiberstufe gemäß der Erfindung stellen sich aufgrund der Schaltung bei vorgegebenem Steuersignal am Eingang E2 und damit des Steuersignals S2 die noch erforderlichen Signale S1 und S3 von selbst her. Es sind jedoch noch Möglichkeiten der Erzeugung der Signale S2 und S3 bei vorgegebenem Signal S1 für die Steuerung des zweiten Transistors T2 gegeben. Hierzu ist eine entsprechende Abstimmung der Pegel und des Zeitverhaltens der Signale S1, S2 und S3 aufeinander angezeigt, wobei bereits oben eine Abstimmung für den Fall der Verwendung einer Konstantspannung als Signal S3 für die Steuerung des Gates des dritten Transistors T3 angegeben wurde.

3 Figuren
12 Patentansprüche

0046216

80 P 1 1 3 4 E

Patentansprüche

1. Treiberstufe für eine statische MOS-Halbleiter-Digitalschaltung, bei der zwei MOS-Feldeffekttransistoren bezüglich ihrer Source-Drainstrecken in Serie liegen und dabei der Drain des ersten MOS-Feldeffekttransistors an ein erstes Betriebspotential und der Sourceanschluß des zweiten MOS-Feldeffekttransistors an ein als Bezugspotential geschaltetes zweites Betriebspotential gelegt ist, bei der ferner der Signalausgang durch einen Schaltungspunkt zwischen dem ersten und dem zweiten Feldeffekttransistor gegeben ist, bei der außerdem das Gate des als Anreicherungstyp-Transistor ausgestalteten zweiten MOS-Feldeffekttransistors signalgesteuert und das Gate des ersten MOS-Feldeffekttransistors an den Signalausgang gekoppelt ist, dadurch gekennzeichnet, daß die Kopplung des Gates des ersten MOS-Feldeffekttransistors (T1) mit dem Ausgang (A) der Treiberstufe durch einen Kondensator (C) gegeben ist, daß außerdem ein dritter MOS-Feldeffekttransistor (T3) vorgesehen ist, dessen Source-Drainstrecke einerseits am Gate des ersten MOS-Feldeffekttransistors (T1) liegt und andererseits durch ein vom Steuersignal (S1) am Gate des zweiten MOS-Feldeffekttransistors (T2) unterschiedliches Steuersignal (S2) beaufschlagt ist.

2. Treiberstufe nach Anspruch 1, dadurch gekennzeichnet, daß ein zur Steuerung des Gates des dritten MOS-Feldeffekttransistors (T3) dienendes Signal (S3) sowohl von dem zur Steuerung des Gates des zweiten MOS-Feldeffekttransistors (T2) dienenden Digitalsignal (S1) als auch von dem zur Steuerung des Sourceanschlusses des dritten MOS-Feldeffekttransistors (T3) dienenden Digitalsignal (S2) verschieden ist.

3. Treiberstufe nach Anspruch 1 oder 2, dadurch gekennzeichnet, daß das zur Beaufschlagung des Gates des dritten MOS-Feldeffekttransistors (T3) vorgesehene Signal
(S3) eine zeitlich konstante Spannung aufweist.

4. Treiberstufe nach einem der Ansprüche 1 bis 3, __da-__
__durch gekennzeichnet__, daß die Summe .... aus dem H-Pegel
des an die Source des dritten MOS-Feldeffekttransistors
(T3) gelegten Digitalsignals (S2) und aus $\overset{\text{der}}{\text{Einsatzspan-}}$
nung des dritten Transistors (T3) größer als der Spannungswert des das Gate des dritten Transistors (T3)
steuernden Signals (S3) ist.

5. Treiberstufe nach Anspruch 1 oder 2, __dadurch gekenn-__
__zeichnet__, daß das zur Steuerung des Gates des zweiten
MOS-Feldeffekttransistors (T2) vorgesehene Digitalsignal
(S1) mit dem zur Steuerung des Gates des dritten MOS-
Feldeffekttransistors (T3) dienenden Signal (S3) identisch ist.

6. Treiberstufe nach einem der Ansprüche 1, 2 oder 5,
__dadurch gekennzeichnet__, daß die Summe aus dem H-Spannungspegel des den Sourceanschluß des dritten MOS-Feldeffekttransistors (T3) steuernden Signals (S2) und der
Einsatzspannung ($U_T$) dieses Transistors (T3) größer als
die L-Spannung des am Gate des dritten MOS-Feldeffekttransistors (T3) liegenden Steuersignals (S3) ist.

7. Treiberstufe nach einem der Ansprüche 1 bis 6, __da-__
__durch gekennzeichnet__, daß das zur Steuerung des Gates
des zweiten MOS-Feldeffekttransistors (T2) vorgesehene
digitale Steuersignal (S1) invertiert zu dem zur Steuerung des Sourceanschlusses des dritten MOS-Feldeffekttransistors (T3) verwendeten Digitalsignals (S2) ist.

8. Treiberstufe nach einem der Ansprüche 1 bis 7, __da-__
__durch gekennzeichnet__, daß die Serienschaltung der beiden ersten MOS-Feldeffekttransistoren (T1, T2) durch
die als Inverter wirkende Serienschaltung eines vierten

0046216

und eines fünften MOS-Feldeffekttransistors (T4, T5)
überbrückt ist, daß dabei das Steuersignal (S2) an das
Gate des am Bezugspotential (M) liegenden vierten MOS-
Feldeffekttransistors (T4) gelegt ist und der am ersten
Betriebspotential ($V_{CC}$) liegende fünfte MOS-Feldeffekttransistor (T5) als Last geschaltet ist, und daß schließlich der Schaltungspunkt zwischen dem vierten und fünften
MOS-Feldeffekttransistor (T4, T5) an das Gate des zweiten
MOS-Feldeffekttransistors (T2) gelegt ist.

9. Treiberstufe nach einem der Ansprüche 1 bis 8, dadurch
gekennzeichnet, daß die Schwellspannung ($U_T$) des ersten
MOS-Feldeffekttransistors (T1) sehr nahe bei 0 Volt, z.B.
im Bereich von - 0,5 Volt bis + 0,5 Volt, liegt.

10. Treiberstufe nach einem der Ansprüche 1 bis 9, dadurch
gekennzeichnet, daß der erste MOS-Feldeffekttransistor (T1)
vom Anreicherungstyp ist.

11. Treiberstufe nach einem der Ansprüche 1 bis 10, dadurch
gekennzeichnet, daß die Source-Drainstrecke des ersten
MOS-Feldeffekttransistors (T1) durch die Source-Drainstrecke
eines weiteren MOS-Feldeffekttransistors (T6) überbrückt
und dieser als Last geschaltet ist.

12. Treiberstufe nach Anspruch 11, dadurch gekennzeichnet,
daß der weitere MOS-Feldeffekttransistor (T6) als Verar-
mungstyp-Transistor ausgestaltet ist.

FIG 1

FIG 2

FIG 3